# EUROPEAN PATENT APPLICATION

(11) **EP 3 916 752 A1**
(43) Date of publication of application: **01.12.2021**
(21) Application number: 20177001.3
(22) Date of filing: 28.05.2020
(51) Int. Cl.: H01J 37/305, G01N 1/42

(54) **DEVICE FOR REDUCING ICE CONTAMINATION OF A SAMPLE, FOCUSED ION BEAM MILLING APPARATUS AND METHOD FOR FOCUSED ION BEAM MILLING OF A SAMPLE**

(71) Applicant: Max-Planck-Gesellschaft zur Förderung der Wissenschaften e.V., 80539 München (DE)
(72) Inventor: Tacke, Sebastian, 44141 Dortmund (DE); Raunser, Stefan, 44287 Dortmund (DE)
(74) Representative: Schulz Junghans Patentanwälte PartGmbB

(57) **Abstract**

The invention relates to a device (100) for reducing ice contamination of a sample (S) in a chamber (210) of a focused ion beam milling apparatus (200), wherein the device (100) comprises a body (110) configured to be cooled to cryogenic temperatures, wherein the body (110) comprises an aperture (111), which is configured such that an ion beam (I) generated by an ion source (220) can pass from the ion source (220) through the aperture (111) to the sample (S), wherein the body (110) comprises a recess (112), wherein said aperture (111) is arranged in the recess (112).

The invention further relates to a focused ion beam milling apparatus (200) and a method for focused ion beam milling of a sample (S).

## Description

The invention relates to a device for reducing ice contamination of a sample, a focused ion beam milling apparatus and a method for focused ion beam milling of a sample. In particular, the sample may be a vitrified biological sample which is to be imaged by cryo electron tomography subsequently to milling.

Electron tomography at cryogenic temperatures (cryo-ET or electron cryotomography) offers the unique possibility to structurally analyze biological macromolecules in their native cellular environment. Using this method, it is even possible to determine protein structures at near atomic resolution by applying sub-volume averaging techniques. One prerequisite for cryo-electron microscopy, particularly cryo-ET, is that the sample is thinner than the inelastic mean-free-path length of electrons, which is approximately 350 nm for 300 keV electrons.

It is known from the prior art to apply a focused ion beam at cryogenic temperatures (cryo-FIB) to thin samples on an electron microscopy grid assembly prior to analysis by cryo-ET. In this method (also termed cryo-focused ion beam milling), the following steps are typically applied: i) vitrification of the sample, ii) identification of regions of interest, iii) rough ablation of the surrounding sample material and iv) polishing of the target region, leaving a thin lamella ready for cryo-ET (Medeiros, J.M et al. Robust workflow and instrumentation for cryo-focused ion beam milling of samples for electron cryotomography, Ultramicroscopy 190, 1-11 (2018)).

Since the vitrified sample acts as a cold trap during the focused ion beam milling procedure, it is especially prone to ice contamination by sublimation of water molecules from the gas phase despite of the high vacuum of the chamber of the milling device. Depending on the partial pressure of water inside the chamber, this effect can be severe and ultimately limits the number of lamellae that can be preserved per milling session.

Recently, a cryo focused ion beam milling device with a stage heater, a cryo-shield and a cryo-shutter was described, which resulted in a significant reduction of ice contamination of the sample allowing longer automated milling sessions (Sebastian Tacke, Philipp Erdmann, Zhexin Wang, Sven Klumpe, Michael Grange, Radim Kříž, Matej Dolník, John Mitchels, Jürgen Plitzko, Stefan Raunser; bioRxiv 2020.02.24.963033; doi: https://doi.org/10.1101/2020.02.24.963033).

By means of the cryo-shutter which was placed in the immediate vicinity of the sample, the contamination rate could be reduced to about 5,6 nm of ice deposition per hour in combination with a cryo-shield cooled with liquid nitrogen.

However, it is still desirable to further reduce ice contamination rates to achieve longer automated milling sessions.

Therefore, the objective of the present invention is to provide a device (i.e., a cryo shutter) which is able to further reduce ice contamination of a sample during cryogenic focused ion beam milling.

This objective is attained by the subject matter of the independent claims. Embodiments of the invention are specified in the dependent claims and described hereafter.

A first aspect of the invention relates to a device for reducing ice contamination of a sample (also referred to as "shutter" or "cryo shutter") in a chamber of a focused ion beam milling apparatus, the focused ion beam milling apparatus comprising an ion source.

The device comprises a body, particularly consisting of a heat conductive material, wherein particularly the body is configured to be arranged in proximity of the sample, e.g. between the sample and an ion source and/or an electron source of the focused ion beam milling apparatus.

The body is configured to be cooled to cryogenic temperatures, i.e. temperatures below -140°C.

The body comprises an aperture, wherein the aperture is configured such that an ion beam generated by the ion source can pass from the ion source through the aperture to the sample when the body is positioned accordingly with respect to the ion source.

A "focused ion beam milling apparatus" as used in the present specification, is an apparatus configured to generate a focused ion beam to thin or mill (i.e. reduce the thickness of) a sample (particularly a vitrified sample, more particularly a vitrified biological sample) by controlled ablation of sample material at specified positions.

In certain embodiments, the aperture comprises a diameter of 1 mm or less, particularly 0,8 mm or less.

In certain embodiments, the body comprises a recess, wherein the aperture is arranged in the recess.

This recess results in a locally reduced thickness of the body. Thereby, the recess allows an ion beam, which is obliquely oriented with respect to the sample (and with respect to a surface of the body), to pass through the aperture even if the aperture is made significantly smaller than in devices of the prior art. A smaller aperture reduces the open surface of the body shielding the sample and thus improves reduction of ice contamination of the sample.

At the same time, due to the recess around the aperture, the remaining body of the device may be designed relatively thick, which improves the heat capacity of the device and provides efficient cooling, further reducing the ice contamination of the sample.

In certain embodiments, the body comprises a first surface, particularly configured to face the sample, and a second surface opposite the first surface, particularly configured to face the ion source.

In certain embodiments, the body comprises a first thickness in the recess and a second thickness outside of the recess, the first thickness and the second thickness extending between the first surface and the second surface in a direction perpendicular to the first surface, wherein the first thickness is smaller than the second thickness.

In certain embodiments, the body comprises a cutout, wherein the recess is arranged in the cutout. In other words, the thickness of the body is reduced in steps around the aperture, the first step being between the main part of the body and the cutout, and the second step being between the cutout and the recess.

This further extends the angle at which an ion beam may pass the aperture. Furthermore, generating such a step during manufacture is easier compared to a gradual decrease of thickness.

In certain embodiments, the body further comprises a third thickness in the cutout outside of the recess, wherein the third thickness is larger than the first thickness and smaller than the second thickness. Therein, in particular, the third thickness extends between the first surface and the second surface parallel to the first thickness and the second thickness.

In certain embodiments, the cutout is arranged in the first surface and/or the second surface.

In certain embodiments, the aperture extends between the first surface and the second surface, wherein 1 % or less, particularly 0,5 % or less, of the surface area of the first surface is open towards the second surface. Therein, the aperture forms at least a part of the open surface.

Therein, in particular, the open surface of the body is minimized by removing all openings which are not strictly necessary (such as an aperture for an electron beam) and by reducing the size of the necessary openings. By reducing the open surface of the body, the cooling effect of the body is improved, resulting in reduced ice contamination of the sample.

The open surface may be continuous, i.e. formed by a single through-hole, or discontinuous, i.e. composed of several separated through-holes between the first surface and the second surface.

In certain embodiments, the recess is arranged in the first surface or the second surface. In certain embodiments, the body comprises a first recess arranged in the first surface and a second recess arranged in the second surface.

In certain embodiments, the body comprises a connecting section configured to be connected to (that is brought into heat conductive contact with) a cold source, such that the body is cooled to cryogenic temperatures by the cold source.

In certain embodiments, the connecting section comprises at least one bore configured to receive a lead configured to conduct heat between the body and the cold source. In particular, the bore comprises an inner thread configured to receive a corresponding outer thread of the lead or a connector which is connected to an end of the lead.

In certain embodiments, the body comprises an opening configured to receive a temperature sensor to determine the temperature of the body, wherein particularly the opening is arranged in the connecting section of the body, wherein more particularly the opening comprises an inner thread configured to receive a corresponding outer thread of the temperature sensor.

The temperature sensor allows accurate control of the temperature of the body which improves the cooling efficiency (leading to reduction of ice contamination) and serves to optimize energy consumption of the cold source.

In certain embodiments, the device comprises an actuator configured to move the body between a first position and a second position, wherein in the first position the body is arranged outside of a beam path of an electron beam from an electron source of the focused ion beam milling apparatus to the sample, such that the electron beam can hit the sample, and wherein in the second position the body is arranged in said beam path, thereby blocking the beam path.

Cryo shutters according to the prior art typically comprise a further aperture for an electron beam used for imaging of the sample in addition to the ion beam. Advantageously, this second aperture is no longer necessary when the body is briefly moved out of the electron beam path by the actuator for obtaining the electron microscopic image. This increases the closed surface of the body and therefore improves the shielding effect of the device, which further reduces ice contamination of the sample.

As used throughout this specification, the term "beam path" designates the path (i.e. the spatial coordinates), along which a beam travels from the respective beam source (ion source or electron source), which depends on the alignment of the beam source. An object being "in the beam path" as used herein means that the object intersects the spatial coordinates along which the beam would travel at the current alignment of the beam source, irrespective of whether a beam is actually generated by the beam source.

In certain embodiments the device comprises a holder configured to hold the body, wherein the holder extends between a first end and a second end, wherein the first end is configured to be connected to the body and the second end is connected or configured to be connected to the actuator.

In certain embodiments, the body comprises at least one hole, wherein the holder comprises at least one pin configured to engage the hole to fix the body to the holder.

In certain embodiments, the holder comprises an isolating element from a thermally isolating material, wherein the isolating element is arranged at the second end of the holder, and wherein the holder is configured to be connected to the actuator via the isolating element.

The isolating element thermally isolates the holder from the outside of the chamber and therefore contributes to cooling of the body, which in turn leads to reduction of ice contamination of the sample.

A second aspect of the invention relates to a focused ion beam milling apparatus comprising a chamber for receiving a sample, an ion source configured to generate an ion beam and a device for reducing ice contamination of a sample according to the first aspect.

The body of the device for reducing ice contamination of a sample is arranged or arrangeable such that the ion beam can pass from the ion source through the aperture of the body of the device to the sample (in particular the body is arranged or arrangeable between the ion source and the sample).

In particular, the body of the device can be arranged at a fixed position in the chamber, or the body of the device may be movable in the chamber, such that is can be arranged such that the ion beam passes through the aperture if desired.

The focused ion beam milling apparatus comprises a cold source configured to cool the body.

In certain embodiments, the focused ion beam milling apparatus further comprises an electron source configured to generate an electron beam.

In certain embodiments, the ion source and the electron source are arranged such that the electron beam generated by the electron source is oriented at an angle of 1° to 89°, particularly 5° to 85°, more particularly 10° to 80°, even more particularly 20° to 70°, most particularly 30° to 60°, with respect to the ion beam generated by the ion source.

In certain embodiments, the device comprises an actuator configured to move the body of the device between a first position and a second position. In the first position the body is arranged outside of a beam path of the electron beam from the electron source to the sample, such that the electron beam can hit the sample. In contrast, in the second position, the body is arranged in the beam path of the electron beam, thereby blocking the beam path.

A third aspect of the invention relates to a method for focused ion beam milling of a sample under cryogenic conditions, particularly using a focused ion beam milling apparatus according to the second aspect, wherein a sample is provided in a chamber of a device for reducing ice contamination of a sample according to the first aspect provided in the chamber (particularly in proximity to the sample), the body of the device is cooled to cryogenic temperatures (i.e., below -140° C) to reduce ice contamination of the sample, wherein particularly the body acts as a cold trap (to condensate/deposit water molecules from the gas phase on the surface of the body), and an ion beam is provided, wherein the ion beam passes through the aperture of the body of the device to the sample to thin the sample at a specified position.

In certain embodiments, the sample is a vitrified sample, particularly a vitrified biological sample, e.g. a sample destined for cryo electron tomography. In certain embodiments, the sample is provided on an electron microscopy grid.

In certain embodiments, an electron beam is provided to image the sample at an angle of 1° to 89°, particularly 5° to 85°, more particularly 10° to 80°, even more particularly 20° to 70°, most particularly 30° to 60°, with respect to the ion beam.

Accordingly, the direction of the ion beam may be non-perpendicular to the second surface of the body of the device. In this arrangement, the recess (and optionally the cutout) of the device improves the angular range of the ion beam, at which passage through the aperture (which is necessary for milling of the sample) is still possible.

In certain embodiments, the body of the device is arranged in the chamber in a first position while the electron beam is provided to image the sample, such that the body of the device is outside of a beam path of the electron beam, and such that the electron beam can hit the sample.

Therein, subsequently to imaging the sample, the body of the device is moved to a second position, such that the body is arranged in the beam path of the electron beam, wherein the ion beam is provided to thin the sample at the specified position while the body is in the second position.

Due to moving the body between the first position and the second position, a second aperture for the electron beam in the body of the device is no longer necessary. In particular, while the body is in the second position, no electron beam is generated by the electron source (although the body is in the beam path of the electron beam.

Wherever alternatives for single separable features are laid out herein as "embodiments", it is to be understood that such alternatives may be combined freely to form discrete embodiments of the invention disclosed herein.

The invention is further illustrated by the following examples and figures, from which further embodiments and advantages can be drawn. These examples are meant to illustrate the invention but not to limit its scope.
- Fig. 1: shows a schematic overview of a part of a chamber of a focused ion beam milling apparatus with a device according to the invention arranged in the chamber;
- Fig. 2: shows an isometric perspective view of a body of a device according to an embodiment of the invention;
- Fig 3: shows a bottom view (A) and sectional views (B, C) of the body shown in Fig. 2;
- Fig. 4: shows a top view of the device according to an embodiment of the invention comprising a body and a holder connected to the body.

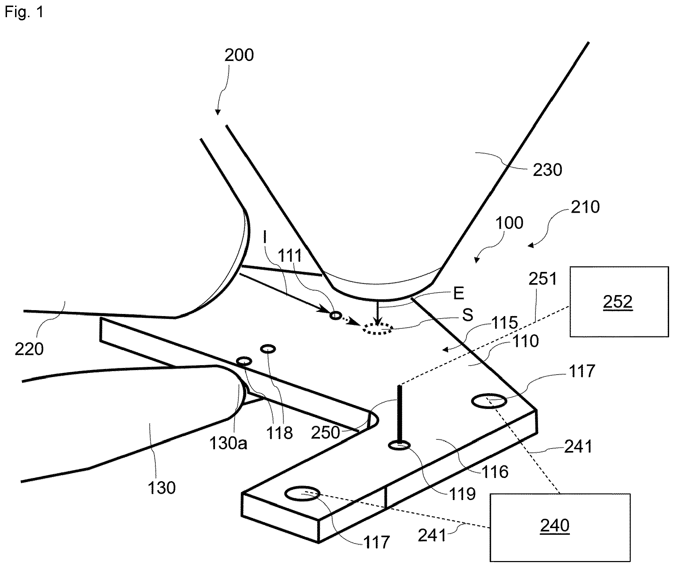

Fig. 1 shows schematically a part of a chamber 210 of a cryogenic focused ion beam milling device 200, in which a vitrified sample S, an ion source 220 (ion column), an electron source 230 (electron column) and a device 100 for reducing the ice contamination of a sample S according to the invention are arranged. The focused ion beam milling device 200 comprises cooling means (not shown) to cool the sample S (e.g. provided in or on a sample stage which is cooled by the cooling means) as well as optional cryo shields/cold traps (not shown) to cryogenic temperatures, i.e. below -140°C. Furthermore, the chamber 210 is kept at a vacuum to reduce water vapor in the atmosphere of the chamber 210, which may result in ice contamination of the sample S, to a minimum. The ion source 220 is configured to generate an ion beam I (along the direction indicated by the arrow marked I) directed at the sample S to reduce the thickness of the sample S at specified positions, which is also described as milling or thinning of the sample S. The electron source 230 is configured to generate an electron beam E (along the direction indicated by the arrow marked E) to image the sample S, particularly by transmission electron microscopy.

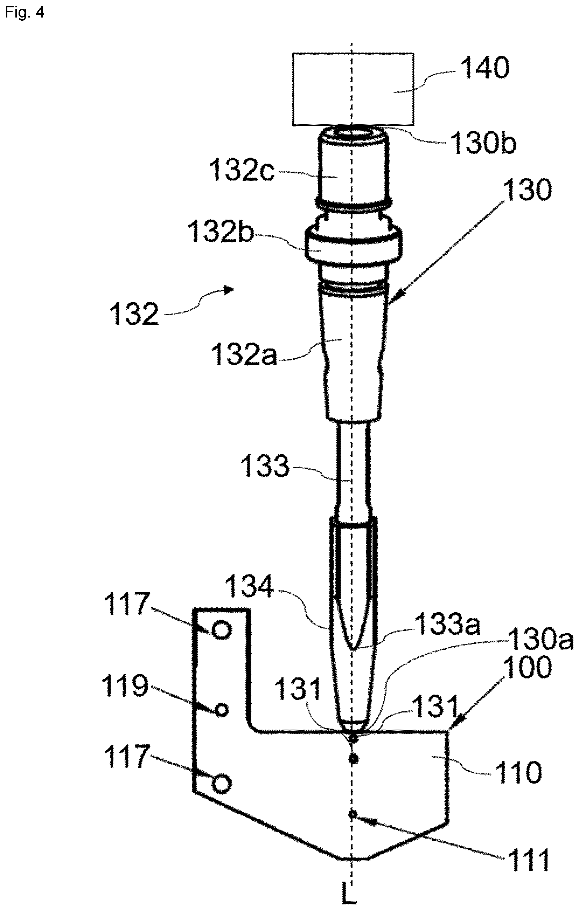

The device 100 comprises a holder 130 and a blade-shaped body 110 connected to the holder 130 at a first end 130a of the holder 130. As shown in Fig. 4, the holder 130 comprises pins 131 at the first end 130a, which insert into corresponding holes 118 on the body 110 of the device 100 to connect the holder 130 to the body 110.

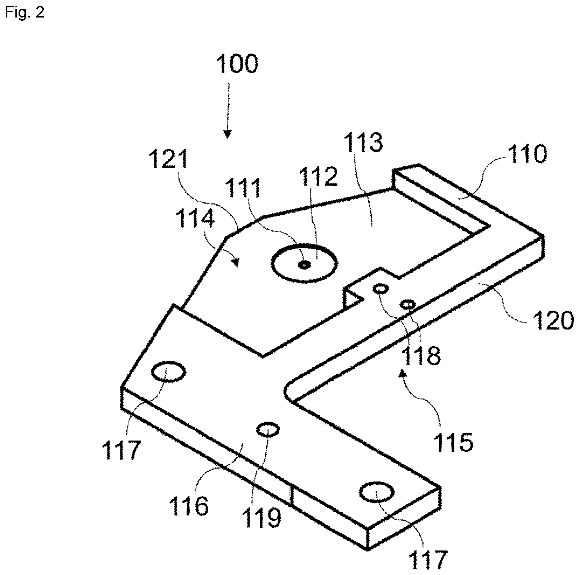

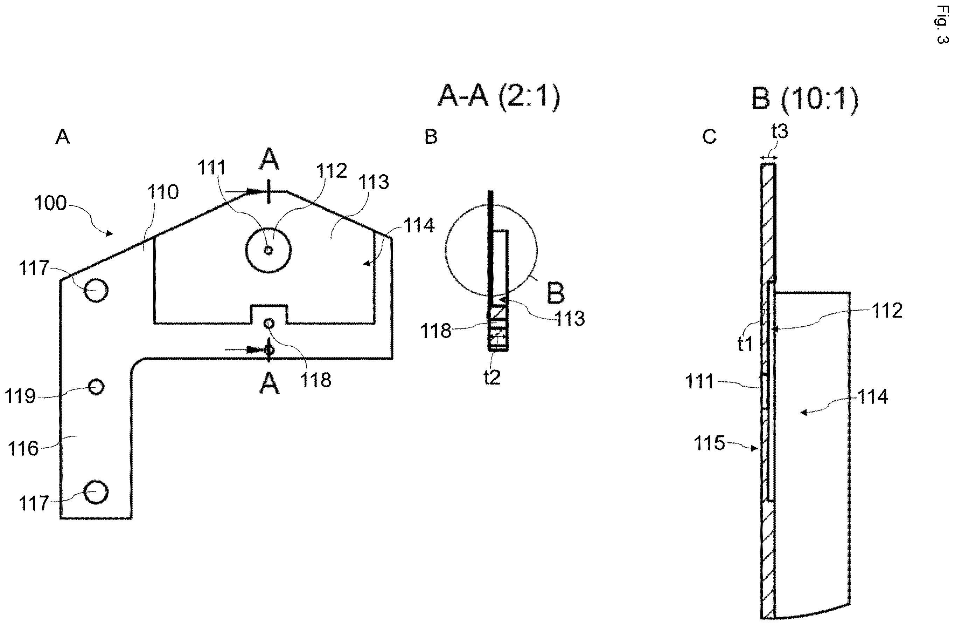

The body 110 is arranged essentially perpendicular to the electron beam E generated by the electron source 230 between the electron source 230 and the sample S with its planar first surface 114 (see Fig. 2 and 3) facing the sample S, and its planar second surface 115 (which is parallel to the first surface 114) oriented towards the electron source 230.

The body 110 of the device 100 is cooled to cryogenic temperatures by a cold source 240 which is connected via two leads 241 (e.g., wires from the heat conductive material such as copper) to a connecting section 116 of the body 110. The leads 241 are connected to the connecting section 116 by insertion of the ends of the leads 241 or connectors attached to the ends of the leads 241 into bores 117 arranged in the connecting section 116 to bring the cold source 240 in heat conductive contact with the body 110.

The cooled body 110 of the device 100 shields the sample S and initiates deposition (e.g. sublimation) of residual water molecules present in the atmosphere of the chamber 210 on the surface of the body 110 (forming a thin layer of ice on the surface) instead of on the sample S. This leads to significantly reduced ice contamination of the sample S.

For example, the cold source 240 which is used to cool the body 110 may be a cryo-shield (not shown) arranged in the chamber 210 which acts as an additional cold trap to sequester water vapor from the atmosphere of the chamber 210, wherein the cryo-shield is particularly cooled by a cryogenic coolant, such as liquid nitrogen.

As shown in Fig. 1 and, in detail in Fig. 2 and 3, the body 110 of the device 100 comprises an aperture 111 extended between the first surface 114 and the second surface 115. The body 110 is arranged with respect to the ion source 220 and the sample S, such that the ion beam I may pass from the ion source 220 through the aperture 111 to the sample S to reduce the thickness of the sample S at specified positions, which is also referred to herein as milling.

Due to geometric constraints of the system, the ion source 220 and the electron source 230 are arranged with respect to each other, such that the ion beam I generated by the ion source 220 and the electron beam E generated by the electron source 230 are oriented at an acute angle (larger than 0° and smaller than 90°, e.g. about 52°) with respect to each other.

Furthermore, a temperature sensor 250 is arranged in an opening 119 of the connecting section 116 of the body 110. The temperature sensor 250 is connected to an analysis unit 252 via a connection 251, which may be e.g. an electric connection or a data connection.

The temperature sensor 250 is used to determine the temperature of the body 110 to be able to control the conditions of the focused ion beam milling process and optimize cooling.

Fig. 2 and 3 show details of the body 110 of the device 100 according to an embodiment of the invention. Fig. 2 shows an isometric perspective view of the body 110, Fig. 3A is a bottom view of the body 110, Fig. 3B is a sectional view along line A-A indicated in Fig. 3A, at 2:1 magnification, and Fig. 3C is a 10:1 enlarged view of detail B indicated in Fig. 3B.

As best seen in Fig. 2, the body 110 has a flat blade like shape and comprises a planar first surface 114 and planar second surface 115 parallel to the first surface 114. Along a direction parallel to the first surface 114 and the second surface 115 the body 110 extends between a straight edge 120 and a flattened tip 121 opposite the straight edge 120. The substantially rectangular connecting section 116 comprising the bores 117 and the opening 119 protrudes from one side of the blade like body 110.

As shown in Fig. 2 and Fig. 3A, the body 110 comprises a substantially rectangular cutout 113 in the first surface 114, resulting in a thickness reduction along a direction perpendicular to the first surface 114 and the second surface 115. A circular recess 112 is arranged centrally in the cutout 113 of the first surface 114 and results in a further stepwise thickness reduction. The above-described aperture 111 is arranged centrally in the recess 112.

In the recess 112, the body 110 comprises a first thickness t1 extending perpendicular to the first surface 114 and the second surface 150 (Fig. 3C). In the cutout 113 outside of the recess 112, the body 110 comprises a third thickness t3 extending parallel to the first thickness t1 (Fig. 3C), wherein the first thickness t1 is smaller than the third thickness t3. Outside of the cutout 113, the body 110 comprises a second thickness t2 parallel to the first thickness t1 and the third thickness t3 (Fig. 3B), wherein the second thickness t2 is larger than the first thickness t1 and the third thickness t3.

Due to the recess 112 and the cutout 113, an ion beam I at angles deviating significantly from 90° with respect to the second surface 115 can pass through the aperture 111, even when the aperture 111 has a relatively small diameter, such as about 0.8 mm. This reduces the open surface area of the body 100 which improves cooling, thereby leading to less ice contamination on the sample S.

Fig. 4 shows the device 100 comprising the above-described body 110 which is connected to a holder 130. The holder 130 extends along the longitudinal axis L between a first end 130a and a second end 130b. The first end 130a is attached to the body 110 by means of the pins 131 inserted into the openings 118 of the body 110, and the second end 130b is mechanically coupled to an actuator 140 configured to move the body 110 with the attached holder 130 between a first position and a second position.

The holder 130 further comprises a rod 133 comprising a rounded tip 133a inserted into a sheath 134, wherein the tip of the sheath 134 forms the first end 130a of the holder 130. The second end 130b of the holder 130 is formed by an isolating element 132 from a thermally isolating material composed of a first part 132a, a second part 130b and the third part 132c arranged along the longitudinal axis L in the direction between the first end 130a and the second end 130b. The second part 132b comprises a ring portion which extends radially outside of the first part 132a and the third part 132c. The isolating element 132 reduces heat transfer from external components to the body 110 and therefore improves the efficiency of cooling.

The actuator 140 is configured to move the holder 130 with the attached body 110 along the longitudinal axis L of the holder 130 between a first position and a second position in the chamber 210 of the focused ion beam milling apparatus 200.

In the first position (not shown) the body 110 is arranged outside of a beam path of the electron beam E from an electron source 230 of the focused ion beam milling apparatus 200. In this configuration, an electron microscopic image of the sample S can be obtained without obstruction of the sample S by the body 110 of the device 100. In contrast, in the second position (shown in Fig. 1), the body 110 is arranged in the beam path of the electron beam E, such that no electron microscopic image of the sample S can be obtained, but such that milling of the sample S can be performed by the ion beam I which passes through the aperture 111 of the device 100.

In certain automated focused ion beam milling procedures, it is not necessary to continuously image the sample S by electron microscopy, but an initial electron microscopic imaging step is performed, followed by an automated focused ion beam milling step (which may take several hours). When the device 100 according to the invention is used in such a method, the body 110 of the device 100 is in the first position during the imaging step, and is subsequently moved to the second position by the actuator 140, such that the cooled body 110 of the device 100 shields the sample S during the milling step, thereby preventing or significantly reducing ice contamination of the sample S.

**List of reference signs**

| | |
|---|---|
| Device for reducing ice contamination of a sample | 100 |
| Body | 110 |
| Aperture | 111 |
| Recess | 112 |
| Cutout | 113 |
| First surface | 114 |
| Second surface | 115 |
| Connecting section | 116 |
| Bore | 117 |
| Hole | 118 |
| Opening | 119 |
| Edge | 120 |
| Tip | 121 |
| Holder | 130 |
| First end | 130a |
| Second end | 130b |
| Pin | 131 |
| Isolating element | 132 |
| First part | 132a |
| Second part | 132b |
| Third part | 132c |
| Rod | 133 |
| Sheath | 134 |
| Actuator | 140 |
| Focused ion beam milling apparatus | 200 |
| Chamber | 210 |
| Ion source | 220 |
| Electron source | 230 |
| Cold source | 240 |
| Lead | 241 |
| Temperature sensor | 250 |
| Connection | 251 |
| Analysis unit | 252 |
| Electron beam | E |
| Ion beam | I |
| Lonqitudinal axis | L |
| Sample | S |

## Claims

1. A device (100) for reducing ice contamination of a sample (S) in a chamber (210) of a focused ion beam milling apparatus (200) comprising an ion source (220), wherein the device (100) comprises a body (110) configured to be cooled to cryogenic temperatures, wherein the body (110) comprises an aperture (111), which is configured such that an ion beam (I) generated by the ion source (220) can pass from the ion source (220) through the aperture (111) to the sample (S),
**characterized in that**
the body (110) comprises a recess (112), wherein said aperture (111) is arranged in the recess (112).

2. The device (100) according to claim 1, **characterized in that** the body (110) comprises a cutout (113), wherein said recess (112) is arranged in the cutout (113).

3. The device (100) according to claim 1 or 2, **characterized in that** the body (110) comprises a first surface (114) and a second surface (115) opposite the first surface (114), wherein the aperture (111) extends between the first surface (114) and the second surface (115), and wherein 1 % or less, particularly 0,5 % or less, of the surface area of the first surface (114) is open towards the second surface (115).

4. The device (100) according to any one of the preceding claims, **characterized in that** the body (110) comprises a connecting section (116) configured to be connected to a cold source (240), such that the body (110) is cooled to cryogenic temperatures by the cold source (240).

5. The device (100) according to claim 4, **characterized in that** the connecting section (116) comprises at least one bore (117) configured to receive a lead (241) configured to conduct heat between the body (110) and the cold source (240), wherein particularly the bore (117) comprises an inner thread configured to receive a corresponding outer thread of the lead (241).

6. The device (100) according to any one of the preceding claims, **characterized in that** the body (110) comprises an opening (119) configured to receive a temperature sensor (250) to determine the temperature of the body (110), wherein particularly the opening (119) is arranged in the connecting section (116) of the body (110), wherein more particularly the opening comprises an inner thread configured to receive a corresponding outer thread of the temperature sensor (250).

7. The device (100) according to any one of the preceding claims, **characterized in that** the device (100) comprises an actuator (140) configured to move the body (110) between a first position and a second position, wherein in the first position the body (110) is arranged outside of a beam path of an electron beam (E) from an electron source (230) of the focused ion beam milling apparatus (200) to the sample (S) and wherein in the second position the body (110) is arranged in said beam path.

8. The device (100) according to claim 7, **characterized in that** the device (100) comprises a holder (130) configured to hold the body (110), wherein the holder (130) extends between a first end (130a) and a second end (130b), wherein the first end (130a) is configured to be connected to the body (110) and the second end (130b) is connected or configured to be connected to the actuator (140), wherein particularly the body (110) comprises at least one hole (118), wherein the holder (130) comprises at least one pin (131) configured to engage the hole (118) to fix the body (110) to the holder (130).

9. The device (100) according to claim 8, **characterized in that** the holder (130) comprises an isolating element (132) from a thermally isolating material, wherein the isolating element (132) is arranged at the second end (130b) of the holder (130), and wherein the holder (130) is configured to be connected to the actuator (140) via the isolating element (132).

10. A focused ion beam milling apparatus (200) comprising a chamber (210) for receiving a sample (S), an ion source (220) configured to generate an ion beam (I) and a device (100) for reducing ice contamination of a sample (S) according to any one of the claims 1 to 9, wherein the body (110) of the device (100) is arranged or arrangeable such that the ion beam (I) can pass through the aperture (111) of the body (110) onto the sample (S), and wherein the focused ion beam milling apparatus (200) comprises a cold source (240) configured to cool the body (110).

11. The focused ion beam milling apparatus (200) according to claim 10, **characterized in that** the focused ion beam milling apparatus (200) comprises an electron source (230) configured to generate an electron beam (E), wherein the ion source (220) and the electron source (230) are arranged such that the electron beam (E) generated by the electron source (230) is oriented at an angle of 1° to 89°, particularly 5° to 85°, more particularly 10° to 80°, even more particularly 20° to 70°, most particularly 30° to 60°, with respect to the ion beam (I) generated by the ion source (220).

12. The focused ion beam milling apparatus (200) according to claim 11, **characterized in that** the device (100) comprises an actuator (140) configured to move the body (110) between a first position and a second position, wherein in the first position the body (110) is arranged outside of a beam path of the electron beam (E) from the electron source (230) to the sample (S), and wherein in the second position the body (110) is arranged in said beam path.

13. A method for focused ion beam milling of a sample (S) under cryogenic conditions, wherein
a. a sample (S) is provided in a chamber (210),
b. a device (100) for reducing ice contamination of a sample (S) according to any one of the claims 1 to 9 is provided in the chamber (210),
c. the body (110) of the device (100) is cooled to cryogenic temperatures to reduce ice contamination of the sample (S),
d. an ion beam (I) is provided, wherein the ion beam (I) passes through the aperture (111) of the body (110) of the device (100) to the sample (S) to thin the sample (S) at a specified position.

14. The method according to claim 13, wherein an electron beam (E) is provided to image the sample (S), wherein the electron beam (E) is oriented at an angle of 1° to 89°, particularly 5° to 85°, more particularly 10° to 80°, even more particularly 20° to 70°, most particularly 30° to 60°, with respect to the ion beam (I).

15. The method according to claim 14, wherein the body (110) of the device (100) is arranged in the chamber (210) in a first position while the electron beam (E) is provided to image the sample (S), such that the body (110) is outside of a beam path of the electron beam (E), and wherein subsequently to imaging the sample (S), the body (110) is moved to a second position, such that the body (110) is arranged in the beam path of the electron beam (E), and wherein the ion beam (I) is provided to thin the sample at the specified position while the body (110) is in the second position.
